# EUROPÄISCHE PATENTSCHRIFT

(11) **EP 0 597 323 B1**
(45) Veröffentlichungstag und Bekanntmachung des Hinweises auf die Patenterteilung: **04.09.1996**
(21) Anmeldenummer: 93117434.6
(22) Anmeldetag: 27.10.1993
(51) Int. Cl.: H01L 23/40

(54) **Vorrichtung zur isolierten Befestigung von wärmeerzeugenden Halbleiter-Bauteilen**
Insulating mounting device for heat generating semi-conductor components
Dispositif pour le montage isolant de composants semi-conducteurs producteurs de chaleur

(30) Priorität: 09.11.1992 DE 4237763
(43) Veröffentlichungstag der Anmeldung: 18.05.1994
(73) Patentinhaber: SIEMENS AKTIENGESELLSCHAFT, 80333 München (DE)
(72) Erfinder: Altendorf, Hans-Walter (Dipl.-Ing.), D-67551 Altendorf (DE); Moritz, Günther, D-68623 Lampertheim (DE)

(56) Entgegenhaltungen:
- EP-A- 0 126 606
- DE-A- 2 918 845
- DE-A- 3 028 722
- DE-A- 3 342 924
- US-A- 3 641 474
- US-A- 4 266 267

## Beschreibung

Die Erfindung bezieht sich auf eine Vorrichtung zur isolierten Befestigung von wärmeerzeugenden Halbleiter-Bauteilen auf einem wärmeabführenden Träger.

Halbleiter-Bauteile werden, wie beispielsweise aus DE-A-36 12 862 bekannt, in der Regel auf wärmeleitenden Trägern, z.B. Kühlblechen od.dgl., befestigt, indem eine metallene Gehäusefläche des Halbleiter-Bauteils unter Zwischenlage eines wärmeleitenden Isolators auf einem wärmeabführenden Träger aufgeschraubt wird. Um die zur Vermeidung von Kriechströmen erforderliche elektrische Trennung herzustellen, ist es erforderlich, zwischen der Befestigungsschraube und der zugehörigen Bohrung in der Gehäusefläche des Halbleiterbauteils eine Isolierbuchse vorzusehen. Eine solche Montage erfordert unter Einbeziehung der unumgänglichen Beilage- und Sicherungsscheiben relativ viele Einzelteile. Außerdem ist bei dieser Anordnung eine relativ schlechte Wärmeleitung gegeben, da die Schrauben durch die Isolierbuchsen thermisch vom Halbleitergehäuse getrennt sind. Die Isolierbuchsen sind außerdem bei größeren Kriech- und Luftstrecken relativ aufwendig herzustellen (Drehteile).

Aus der JP-61-50354 ist es bekannt, das wärmeableitende Kühlblech mit dem HL-Bauteil zu verbinden, indem auf das Kühlblech ein Befestigungsteil aus Isoliermaterial aufgesetzt wird, welches das HL-Bauteil an zwei Seiten klammerartig umschließt. Eine Zentrierung der Teile erfolgt mittels eines zylindrischen Zapfens am Befestigungsteil, der durch Bohrungen im Kühlblech und im HL-Bauteil greift.

Aus der JP-57-99762 ist es ferner bekannt, eine wärmeableitende Kühlplatte am HL-Bauteil dadurch zu befestigen, indem eine an der Kühlplatte angeformte Buchse durch eine Bohrung des Wärmeleitblechs des HL-Bauteils greift und durch konisches Aufspreizen mit diesem verbunden wird. Eine elektrische Isolation zwischen den Teilen ist hier nicht vorgesehen.

Bekannt ist es ebenfalls, Halbleiter-Bauteile mit Klammern auf Isolierscheiben zu befestigen. Eine solche Anordnung hat jedoch den Nachteil, daß relativ viel Platz benötigt wird. Wenn viele Bauteile auf kleinem Platz unterzubringen sind, ist außerdem die Handhabung bei der Montage schwierig.

Eine weiterhin bekannte Lösung, Kühlkörper herzustellen, die mit Epoxidharz beschichtet sind, führt lediglich zu einer Einsparung des zwischen dem Halbleiterbauteil und dem Kühlblech vorgesehenen Isolators; die Nachteile der Isolierbuchse bzw. der Klammern zur Befestigung des Halbleiterbauteils bleiben nach wie vor erhalten.

Der im Anspruch 1 angegebenen Erfindung liegt die Aufgabe zugrunde, eine Vorrichtung der eingangs genannten Art dahingehend zu verbessern, daß insbesondere bei geringerem Aufwand an Teilen und Montage eine ausreichend gute Wärmeabfuhr gewährleistet ist.

Dadurch, daß erfindungsgemäß auf dem wärmeleitenden Träger, der vorzugsweise ein Aluminiumdruckgußteil sein kann, ein gut wärmeleitender Isolator, vorzugsweise ein Polyamid des Typs PA 6, aufgespritzt ist, und in diesem Isolator gleichsam die Befestigungspunkte integriert sind, wird eine sehr einfache und kostengünstige Herstellung und Montage erzielt, die sich insbesondere dann als besonders vorteilhaft erweist, wenn mehrere Halbleiterbauteile auf dem Träger zu montieren sind.

Weitere Vorteile sind darin zu sehen, daß bei entsprechend konstruktiver Gestaltung des Trägers eine Führung bzw. Halterung für Leiterplatten vorgesehen werden kann. In den Isolator können mit weiterem Vorteil Leiterbahnen angeordnet sein, die beispielsweise vor dem Spritzgießvorgang in das Spritzwerkzeug eingebracht werden. Weitere Vorteile ergeben sich aus den Unteransprüchen und der nachstehenden Beschreibung eines Ausführungsbeispieles.

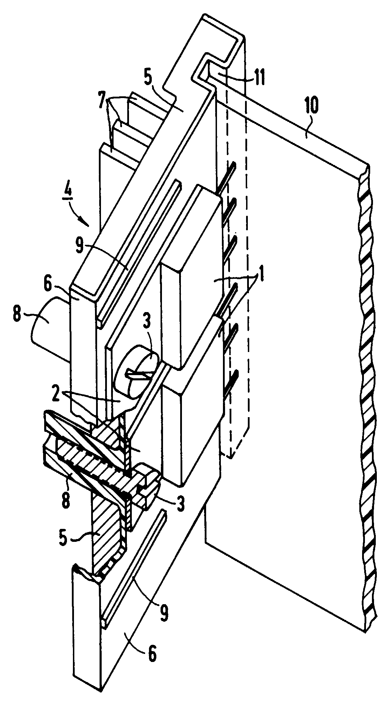

Die einzige Figur zeigt in einer schaubildlichen Darstellung und teilweise im Schnitt die erfindungsgemäße Vorrichtung am Beispiel einer Befestigung von zwei Halbleiterbauteilen.

Die in der Figur mit 1 bezeichneten Halbleiter-Bauteile weisen in bekannter Weise Wärmeleitbleche 2 auf, die üblicherweise mit Befestigungsschrauben 3 an einem Träger 4 befestigt werden. Der Träger 4 besteht hier vorteilhafterweise aus einem wärmeabführenden Metallkörper 5 und, den Halbleiterbauteilen 1 zugewandt, einem Isolationskörper 6. Der Metallkörper 5 ist vorteilhafterweise ein Aluminiumdruckgußteil, welches gegebenenfalls ein oder mehrere Kühlrippen 7 enthalten kann.

Der Isolationskörper 6 ist formschlüssig mit dem Metallkörper 5 verbunden und vorteilhafterweise auf diesen aufgespritzt. Als Isolatormaterial kann mit Vorteil ein Thermoplast verwendet werden. Dieses Material ist aufgrund seiner Eigenschaften leicht fließfähig, was an sich in Verbindung mit Wärmeerzeugern unerwünscht ist, was jedoch, wie Versuche gezeigt haben, insofern von Vorteil ist, als nach der Befestigung der Halbleiterbauteile am Träger 4 durch ein geringes Nachfließen des Isoliermaterials eine innige Verbindung mit den Wärmeleitblechen des Halbleiters zustandekommt. Dadurch wird ein optimaler Wärmeübergang erzielt, so daß auf Wärmeleitpasten oder ähnliche, den Wärmeübergang verbessernde Materialien verzichtet werden kann. Als besonders vorteilhaft hat sich die Verwendung von Polyamid 6, einem Thermoplast mit Glasfaserbeimischung, erwiesen.

Der Isolationskörper 6 weist an den Befestigungspunkten einstückig angeformte Isolationsbuchsen 8 auf, die so gestaltet sind, daß beim Einschrauben der Befestigungsschrauben 3 eine leichte Spreizwirkung erzeugt und dadurch eine sichere Verbindung der Bauteile erzielt wird. Durch unterschiedliche Materialdicke kann unterschiedlichen Anforderungen an Kriech- bzw. Luftstrecken Rechnung getragen und der Wärmeübergang am Wärmeleitblech des Halbleitergehäuses optimiert werden. Da die Befestigungspunkte direkt mit dem Wärmeleitblech der Halbleiterbauteile verbunden sind, werden die Nachteile thermisch isolierter Schrauben, wie eingangs erläutert, vermieden.

Um das Fließverhalten beim Spritzvorgang zu verbessern, ist es vorteilhaft, an mehreren Stellen vorteilhafterweise auch zwischen den Halbleiterbauteilen quer verlaufende, in der Figur mit 9 angedeutete Stege bzw. Erhebungen vorzusehen.

Durch geeignete konstruktive Gestaltung des Trägers 4 kann gleichsam eine isolierte Befestigung einer Leiterplatte, in der Figur mit 10 bezeichnet, vorgesehen werden. Im gezeigten Ausführungsbeispiel ist eine längs verlaufende Nut 11 vorgesehen, in die die Leiterplatte 10 eingesteckt wird.

Wenn eine sehr hohe Abstrahlung verlangt wird, kann der Metallkörper 5, wie bereits erwähnt, mit diversen Kühlrippen (Pos. 7) versehen sein. Alternativ kann der Metallkörper auch als Gehäuse ausgebildet oder Teil eines Gehäuses sein. Schließlich ist der vorgenannte Aufbau mit entsprechend vorzusehenden Isolationsmaterialien auch als Träger für Halbleiterchips denkbar.

## Patentansprüche

1. Vorrichtung zur isolierten Befestigung von wärmeerzeugenden Halbleiter-Bauteilen auf einem wärmeabführenden Träger,
**dadurch gekennzeichnet,**
daß der Träger (4) aus einem Metallkörper (5) und einem formschlüssig und fest mit diesem verbundenen Isolationskörper (6) gebildet ist und daß am Isolationskörper (6) Isolationsbuchsen (8) einstückig angeformt sind, die im montierten Zustand durch Ausnehmungen im Metallkörper hindurchgreifen, wobei die Isolationsbuchsen (8) so dimensioniert sind, daß sie lösbare Befestigungsmittel (3) zur Befestigung der Halbleiter-Bauteile aufnehmen.

2. Vorrichtung nach Anspruch 1,
**dadurch gekennzeichnet,**
daß der Isolationskörper (6) am Metallkörper (5) aufgespritzt ist.

3. Vorrichtung nach Anspruch 2,
**dadurch gekennzeichnet,**
daß als Isolationsmaterial ein Thermoplast, vorzugsweise Polyamid 6, verwendet ist.

4. Vorrichtung nach Anspruch 2,
**dadurch gekennzeichnet,**
daß der Isolationskörper (6) mit mehreren, vorzugsweise jeweils zwischen zwei zu befestigenden Halbleiter-Bauteilen (1) angeordneten Stegen (9) versehen ist.

5. Vorrichtung nach Anspruch 2,
**dadurch gekennzeichnet,**
daß der Isolationskörper (6) durch seine konstruktive Gestaltung mindestens eine Führungsnut (11) zur Aufnahme mindestens einer Leiterplatte (10) enthält.

6. Vorrichtung nach einem der Ansprüche 1 bis 5,
**dadurch gekennzeichnet,**
daß in dem Isolationskörper (6) Leiterfolien eingearbeitet sind.

7. Vorrichtung nach einem der Ansprüche 1 bis 6,
**dadurch gekennzeichnet,**
daß der Metallkörper (5) mit angeformten Kühlrippen (7) versehen ist.

8. Vorrichtung nach einem der Ansprüche 1 bis 7,
**dadurch gekennzeichnet,**
daß der Metallkörper (5) Teil eines Gehäuses bildet.

9. Vorrichtung nach einem der Ansprüche 1 bis 8,
**dadurch gekennzeichnet,**
daß der Metallkörper (5) ein Aluminiumdruckgußteil ist.

## Claims

1. Device for securing heat-generating semiconductor components to a heat-dissipating carrier in an insulated manner, characterised in that the carrier (4) is constructed from a metal body (5) and an insulating body (6), which is securely connected to the latter in a form-locking manner, and in that preformed in one piece on the insulating body (6) are insulating bushings (8) which in the mounted state reach through cut-outs in the metal body, with the insulating bushings (8) being dimensioned in such a way that they receive removable securing means (3) for securing the semiconductor components.

2. Device according to claim 1, characterised in that the insulating body (6) is sprayed on the metal body (5).

3. Device according to claim 2, characterised in that a thermoplast, preferably polyamide 6, is used as insulating material.

4. Device according to claim 2, characterised in that the insulating body (6) is provided with a plurality of bars (9) which are preferably arranged in each case between two semiconductor components (1) which are to be secured.

5. Device according to claim 2, characterised in that the insulating body (6), as a result of its constructional design, contains at least one guide groove (11) for receiving at least one printed-circuit board (10).

6. Device according to one of the claims 1 to 5, characterised in that conductor foils are incorporated in the insulating body (6).

7. Device according to one of the claims 1 to 6, characterised in that the metal body (5) is provided 5 with preformed cooling ribs (7).

8. Device according to one of the claims 1 to 7, characterised in that the metal body (5) forms part of a housing.

9. Device according to one of the claims 1 to 8, characterised in that the metal body (5) is an aluminium die-cast part.

## Revendications

1. Dispositif de fixation isolée de composants à semiconducteur produisant de la chaleur sur un support dissipant de la chaleur,
caractérisé en ce que
le support (4) est formé d'un corps (5) métallique et d'un corps (6) isolant relié avec complémentarité de forme et rigidement à celui-ci, des douilles (8) d'isolation, qui sont d'une pièce et qui, à l'état monté, passent dans des évidements ménagés dans le corps métallique, étant issues du corps (6) d'isolation, les douilles (8) d'isolation ayant des dimensions telles qu'elles reçoivent des moyens (3) amovibles destinées à la fixation des composants à semiconducteur.

2. Dispositif suivant la revendication 1,
caractérisé en ce que
le corps isolant (6) est appliqué au pistolet au corps (5) métallique.

3. Dispositif suivant la revendication 2,
caractérisé en ce que
il est utilisé comme matériau isolant un thermoplastique, de préférence du polyamide 6.

4. Dispositif suivant la revendication 2,
caractérisé en ce que
le corps (6) isolant est muni de plusieurs barrettes (9) disposées de préférence chacune entre deux composants (1) à semiconducteur à fixer.

5. Dispositif suivant la revendication 2,
caractérisé en ce que
le corps isolant (6) comprend de par la forme de sa construction au moins une rainure (11) de guidage pour la réception d'au moins une carte (10) à circuits imprimés.

6. Dispositif suivant l'une des revendications 1 à 5,
caractérisé en ce que
des feuilles de conducteurs sont ménagées dans le corps (6) d'isolation.

7. Dispositif suivant l'une des revendications 1 à 6,
caractérisé en ce que
le corps métallique (5) est muni de nervures (7) moulées de refroidissement.

8. Dispositif suivant l'une des revendications 1 à 7,
caractérisé en ce que
le corps métallique (5) fait partie d'un boîtier.

9. Dispositif suivant l'une des revendications 1 à 8,
caractérisé en ce que
le corps métallique (5) est une pièce d'aluminium obtenue par coulée sous pression.
